Europäisches Patentamt

European Patent Office

Office européen des brevets

(11) Veröffentlichungsnummer: **0 644 429 A2**

## (12) EUROPÄISCHE PATENTANMELDUNG

(21) Anmeldenummer: **94114949.4**

(22) Anmeldetag: **22.09.94**

(51) Int. Cl.6: **G01R 11/00**

(30) Priorität: **22.09.93 DE 4332252**

(43) Veröffentlichungstag der Anmeldung:
**22.03.95 Patentblatt 95/12**

(84) Benannte Vertragsstaaten:
**AT CH DE FR GB IT LI NL SE**

(71) Anmelder: **SIEMENS AKTIENGESELLSCHAFT**
**Wittelsbacherplatz 2**
**D-80333 München (DE)**

(72) Erfinder: **Müller, Andreas, Dipl.-Ing.**
**Kleinschmidt-Strasse 11**
**D-60431 Frankfurt (DE)**
Erfinder: **Steinmüller, Günter, Dipl.-Ing. (FH)**
**Laufamholzstrasse 65**
**D-90482 Nürnberg (DE)**

(54) **Drehstrom-Dreileiterzähler mit drei Messsystemen.**

(57) Es wird mit einfachen Mitteln aufgrund von Strommessungen ($I_r$, $I_t$) in zwei Phasen (R, T) der Strom der dritten Phase $I_s$ gebildet. Hierzu sind die Ausgänge zweier Anpaßwandler (3, 4), die zur Transformation der beiden Phasenströme dienen, mit den Eingängen (E1, E2) eines summierenden und invertierenden Verstärkers (5, 19) verbunden. Dieser bildet den dritten Strom ($I_s$) gemäß der Beziehung $I_s = -(I_r + I_t)$. Der Drehstromzähler kann gleichzeitig zur Wirk- und Blindleistungsmessung in einem Drehstrom-Dreileiternetz (R, S, T) ohne Null-Leiter benutzt werden.

FIG 1

Die Erfindung bezieht sich auf einen Drehstromzähler zum Anschluß an ein Drehstrom-Dreileiternetz mit den Phasen R, S, T, mit drei internen Meßsystemen, mit nur zwei Netzleiter-Stromwandlern, wobei in zwei Phasen des Netzes jeweils einer der Netzleiter-Stromwandler zur Messung des Phasenstroms geschaltet ist, und mit einer Schaltung, die aus dem Stromabbild der beiden Phasenströme das Stromabbild des dritten Phasenstroms gemäß der Gleichung $I_s = -(I_r + I_t)$ erzeugt.

Drehstromzähler der oben genannten Art sind bekannt. In der Siemens-Broschüre "Schaltpläne für Elektrizitätszähler", Best.-Nr. J410/1067, ist eine Schaltung mit einem Drehstrom-Vierleiterzähler in einer Drehstrom-Dreileiteranlage mit -aus Kostengründen - nur zwei externen Netzleiter-Stromwandlern offenbart. Bei dieser Schaltung kann stets nur ein einziger Zähler, der z.B. zur Wirk- oder Blindleistungsmessung vorgesehen ist, angeschlossen werden. Die beiden durch die Netzleiter-Stromwandler übersetzten Phasenströme $I_R$ und $I_T$ werden nicht nur zur Leistungsmessung in den betreffenden Phasen R und T in zwei Meßwerken, sondern auch zur Leistungsmessung in der Phase S in einem weiteren Meßwerk verwendet. Hierzu werden die beiden durch die Netzleiter-Stromwandler heruntertransformierten Ströme $I_R$ und $I_T$ in entgegengesetzter Durchflußrichtung durch das Meßwerk zur Leistungsmessung der Phase S geleitet, was dem Stromfluß $I_s$ gemäß der Beziehung $I_s = -I_r - I_t$ entspricht.

Der Anschluß von zwei oder mehr Zahlern an einen Stromwandler pro Phase zur Wirk- oder Blindleistungsmessung ist mit dieser sogenannten "Kunstschaltung" nicht möglich. Darüber hinaus ist eine elektronische Meßwertverarbeitung nicht möglich, weil die Netzleiter-Stromwandler Ströme mit zu hohen Stromwerten abgeben.

Es ist bei der Gestaltung eines elektrischen Zählers wünschenswert, aus Kostengründen mit nur zwei Netzleiter-Stromleitern auszukommen. Der Nachteil der bekannten "Kunstschaltung", nämlich daß mehrere Zähler nicht in Reihe geschaltet werden können, soll allerdings beseitigt sein.

Der Erfindung liegt die Aufgabe zugrunde, einen Drehstromzähler der oben genannten Art anzugeben, in dem mit einfachen Mitteln aufgrund der Strommessung in zwei Phasen der Strom der dritten Phase gebildet wird, so daß hiermit zum Beispiel gleichzeitig eine Wirk- und Blindleistungsmessung ohne eine "Kunstschaltung" möglich ist. Die Messung soll dabei an einem Drehstromnetz ohne Null-Leiter möglich sein.

Die Erfindung beruht auf der Überlegung, daß dies durch einen Übergang von einem Drehstrom-Vierleiterzähler auf einen Drehstrom-Dreileiterzähler bewirkt werden kann.

Diese Aufgabe wird erfindungsgemäß dadurch gelöst, daß zwei Anpaßwandler vorgesehen sind, die zur Erzeugung eines zur weiteren Verarbeitung geeigneten Stromabbildes der Phasenströme dienen, und daß anstelle der Schaltung ein invertierender Summier-Verstärker vorgesehen ist, dessen Eingänge jeweils mit den Ausgängen der Anpaßwandler elektrisch verbunden sind und der aus den ihm zugeführten Größen das Stromabbild gemäß der genannten Gleichung bildet.

Ein Vorteil der erfindungsgemäßen Lösung besteht darin, daß zwei oder mehr derartige Drehstrom-Dreileiterzähler hintereinander geschaltet werden können. Das kann sinnvoll sein, wenn ein Kontrollzähler notwendig ist, z.B. an einem entfernten Ort, oder wenn eine Wirk- und gleichzeitig eine Blindleistungsmessung erforderlich ist. Bei der eingangs erwähnten, zum Stand der Technik gehörenden "Kunstschaltung" ist dies nicht möglich, denn hier wird aufgrund der Verschaltung der beiden externen Stromwandler der Strom im einen Stromwandler teilweise über den anderen Stromwandler zurückgeleitet.

Weitere vorteilhafte Ausgestaltungen der Erfindung sind den Unteransprüchen zu entnehmen.

Ausführungsbeispiele der Erfindung werden im folgenden anhand einer Zeichnung näher erläutert. Es zeigen:

FIG 1    eine Prinzipschaltung eines erfindungsgemäßen Drehstrom-Dreileiterzählers,

FIG 2    die Schaltung eines erfindungsgemäßen Drehstrom-Dreileiterzählers mit Strom-Stromwandlern und

FIG 3    die Schaltung eines erfindungsgemäßen Drehstrom-Dreileiterzählers mit Strom-Spannungswandlern.

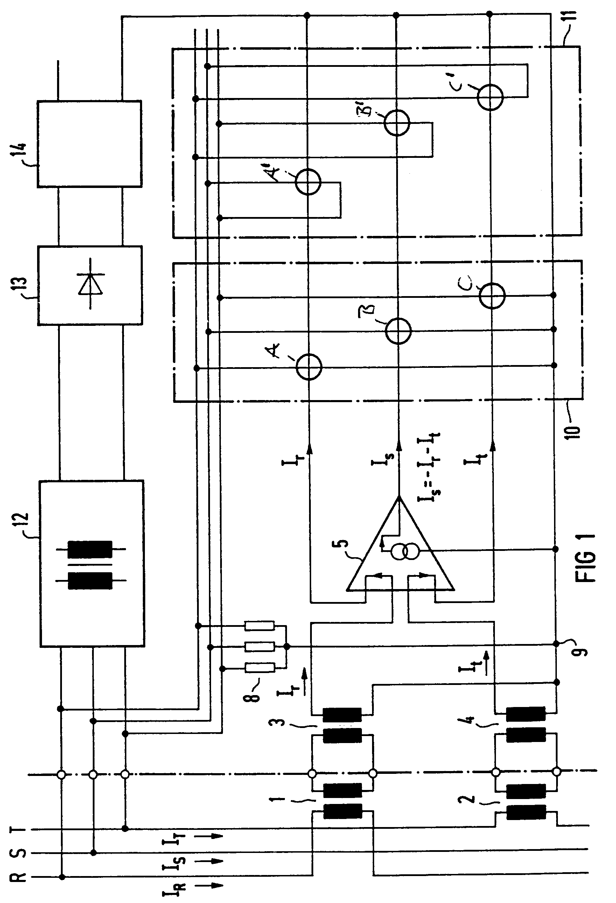

In FIG 1 ist ein Drehstrom-Dreileiternetz mit den Phasen R, S, T mit einem Netzleiter-Stromwandler 1 in der Phase R und mit einem weiteren Netzleiter-Stromwandler 2 in der Phase T gezeigt. Ein Null-Leiter ist nicht vorgesehen. In der Phase S ist kein Netzleiter-Stromwandler angeordnet, um Kosten zu sparen. Die beiden externen Stromwandler 1, 2 haben üblicherweise in Niederspannungsnetzen eine Übersetzung von 1000 A auf 5 A. Mit diesem Wandlersatz 1, 2 soll aufgabengemäß eine Wirkleistungs- und/oder Blindleistungsmessung, bevorzugt beides gleichzeitig, möglich sein. Hierzu weist der Drehstrom-Dreileiterzähler intern Anpaßwandler 3 und 4 auf, die primärseitig an die Stromwandler 1, 2 angeschlossen sind und die jeweils den Phasenstrom $I_R$ bzw. $I_T$ auf eine zur elektronischen Weiterverarbeitung geeignete Größe heruntertransformieren. Man erhält somit auf der Sekundärseite des Stromwandlers 3 das Stromabbild $I_r$ des Phasenstroms $I_R$ und auf der Sekundärseite des Stromwandlers 4 das Stromabbild $I_t$ des Pha-

senstroms $I_T$. Die beiden Strom-Stromwandler 3, 4 sind jeweils mit dem Eingang eines symbolisch veranschaulichten Verstärkers 5 verbunden, durch den die Stromabbilder $I_r$ und $I_t$ summiert werden und durch den die Summe invertiert wird, so daß am Ausgang des Operationsverstärkers 5 das Stromabbild $I_s = -(I_r + I_t)$ ansteht. Somit stehen die drei Ströme $I_r$, $I_s$ und $I_t$ zur Verfügung. Sie werden einem Meßsystem 10 mit Meßwerken A, B, C zur Wirkleistungsmessung und einem Meßsystem 11 mit Meßwerken A', B', C' zur Blindleistungsmessung zugeführt. Die gesamte Schaltung hat als gemeinsames Bezugspotential einen Schaltungspunkt 9, der als künstlicher Sternpunkt in üblicher Weise durch Anschluß eines ohmschen Netzwerks 8 an die Phasen R, S, T gebildet ist. An diesem Bezugspunkt 9 ist jeweils eine Ausgangsklemme der Stromwandler 3, 4 angeschlossen. Die Phasenleiterspannungen sind ebenfalls in üblicher Weise an die Meßsysteme 10 und 11 geführt. Am Dreileiternetz R, S, T ist außerdem die Reihenschaltung aus einem Spannungstransformator 12, einem Gleichrichter 13 und einer Spannungsstabilisierungsschaltung 14 angeschlossen.

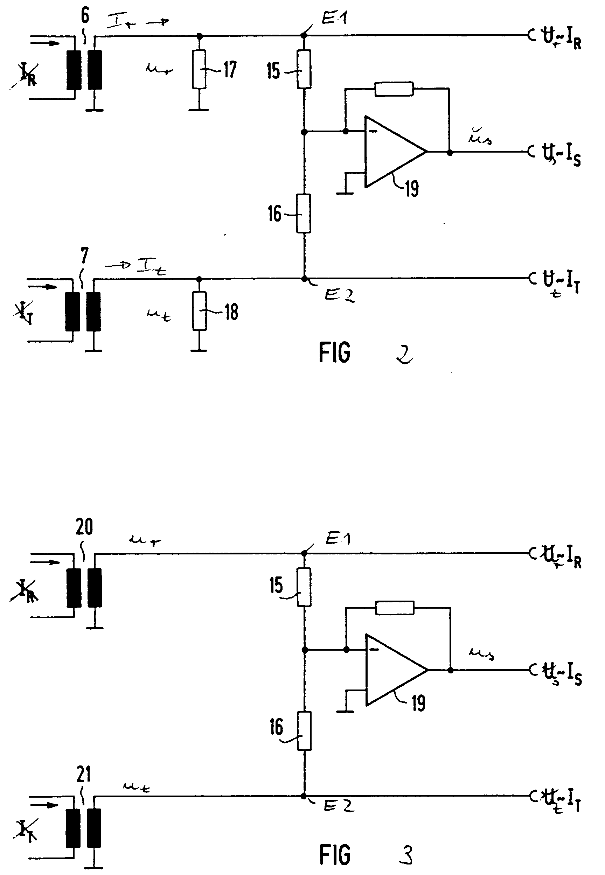

FIG 2 und 3 zeigen Ausführungsbeispiele, bei denen zur Verarbeitung der Größen $I_r$, $I_s$ und $I_t$ für die Wirk- und Blindleistungsmessungen Spannungen zur Verfügung gestellt werden. Daher sind in der Schaltung 2 die Strom-Stromwandler 6, 7, die den Stromwandlern 3 bzw. 4 entsprechen, mit den Bürdenwiderständen 17, 18 beschaltet. An diesen Widerständen 17, 18 fallen proportionale Spannungen $u_r$, $u_t$ ab. Es wird mit Hilfe des Verstärkers 19 die fehlende Spannung $u_s$, die proportional zu $I_s$ ist, gebildet. In FIG 3 sind Strom-Spannungswandler 20, 21 vorgesehen. Hier fallen die Widerstände 17, 18 weg. Die Ausgänge der Wandler 6, 7 sowie 20, 21 sind über Widerstände 15 bzw. 16 an die Eingänge E1, E2 eines invertierenden Operationsverstärkers 19 geschaltet. An dessen Ausgang ergibt sich somit das Stromabbild $I_s = -(I_r + I_t)$. Die Beschaltungswiderstände sind mit 15 und 16 bezeichnet. Der Verstärker 19 ist jeweils an Masse angeschlossen.

## Patentansprüche

1. Drehstromzähler zum Anschluß an ein Drehstrom-Dreileiternetz mit den Phasen R, S, T, mit drei internen Meßsystemen (A, B, C; A', B', C'), mit nur zwei Netzleiter-Stromwandlern (1, 2), wobei in zwei Phasen (R, T) des Netzes jeweils einer der Netzleiter-Stromwandler (1, 2) zur Messung des Phasenstroms ($I_R$, $I_T$) geschaltet ist, und mit einer Schaltung, die aus dem Stromabbild ($I_r$, $I_t$) der beiden Phasenströme ($I_R$, $I_T$) das Stromabbild ($I_S$) des dritten Phasenstroms ($I_S$) gemäß der Gleichung $I_S =$

$-(I_r + I_t)$ erzeugt,
**dadurch gekennzeichnet,** daß zwei Anpaßwandler (3, 4 bzw. 6, 7 bzw. 20, 21) vorgesehen sind, die zur Erzeugung eines zur weiteren Verarbeitung geeigneten Stromabbildes ($I_r$, $I_t$; $u_r$, $u_t$) der Phasenströme ($I_R$, $I_T$) dienen, und daß anstelle der Schaltung ein invertierender Summier-Verstärker (5, 19) vorgesehen ist, dessen Eingänge jeweils mit den Ausgängen der Anpaßwandler (3, 4 bzw. 6, 7 bzw. 20, 21) elektrisch verbunden sind und der aus den ihm zugeführten Größen ($I_r$, $I_t$) das Stromabbild ($I_s$) gemäß der genannten Gleichung bildet.

2. Drehstromzähler nach Anspruch 1, **dadurch gekennzeichnet,** daß die Anpaßwandler als Strom-Stromwandler (6, 7) ausgeführt sind (Fig. 2).

3. Drehstromzähler nach Anspruch 1, **dadurch gekennzeichnet,** daß die Anpaßwandler als Strom-Spannungswandler (20, 21) ausgeführt sind (Fig. 3).

4. Drehstromzähler nach einem der Ansprüche 1 bis 3, **dadurch gekennzeichnet,** daß dem Verstarker (5, 19) ein Meßwerk (10) zur Wirkleistungsmessung nachgeschaltet ist.

5. Drehstromzähler nach einem der Ansprüche 1 bis 4, **dadurch gekennzeichnet,** daß dem Verstärker (5, 19) ein Meßwerk (11) zur Blindleistungsmessung nachgeschaltet ist.

6. Drehstromzähler nach einem der Ansprüche 1 bis 5, **dadurch gekennzeichnet,** daß der Verstarker (5, 19) ein elektronischer Operationsverstärker ist.

7. Drehstromzähler nach einem der Ansprüche 1 bis 6, **dadurch gekennzeichnet,** daß der Verstärker (5, 19) an einen gemeinsamen Bezugspunkt (9) gelegt ist, der bevorzugt durch Widerstände (8) gebildet ist.

FIG 1

EP 0 644 429 A2

FIG 2

FIG 3